# EUROPEAN PATENT APPLICATION

(11) **EP 4 468 322 A1**
(43) Date of publication of application: **27.11.2024**
(21) Application number: 22921987.8
(22) Date of filing: 02.09.2022
(51) Int. Cl.: H01L 21/304, B23Q 3/08, B24B 1/00, B24B 41/06, H01L 21/683

(54) **CHUCK DEVICE**

(30) Priority: 20.01.2022 JP 2022007224
(71) Applicant: DENSO CORPORATION, Kariya-city, Aichi 448-8661 (JP); OSAKA UNIVERSITY, Suita-shi Osaka 565-0871 (JP)
(72) Inventor: HORI, Kantaro, Kariya-city, Aichi 4488661 (JP); SOLTANI, Bahman, Kariya-city, Aichi 4488661 (JP); AOKI, Kazufumi, Kariya-city, Aichi 4488661 (JP); MARUNO, Naoki, Kariya-city, Aichi 4488661 (JP); KATO, Yuya, Kariya-city, Aichi 4488661 (JP); YAMAMURA, Kazuya, Suita-shi, Osaka 565-0871 (JP); YANG, Xu, Suita-shi, Osaka 565-0871 (JP)
(74) Representative: Kuhnen & Wacker Patent- und Rechtsanwaltsbüro PartG mbB
(86) International application number: PCT/JP2022/033153
(87) International publication number: WO 2023/139834

(57) **Abstract**

A chuck apparatus (2) is configured to hold a wafer (W) during planarization of the wafer with the aid of anodizing. The chuck apparatus includes a chuck cover (22), a suction portion (23), and an energizing portion (24). The suction portion (23) includes a suction surface (20) that suctions the wafer (W). The energizing portion (24) is provided in the suction portion (23) so as to come into contact and energize the wafer (W) suctioned by the suction portion (23). The chuck cover (22) covers the suction portion (23) and the energizing portion (24) in an insulating manner while exposing the suction surface (20).

## Description

### [Cross-Reference to Related Application]

The present application is based on and claims the benefit of priority from Japanese Patent Application No. 2022-007224, filed on January 20, 2022, the description of which is incorporated herein by reference.

### [Technical Field]

The present disclosure relates to a chuck apparatus that holds a wafer.

### [Background Art]

Various technologies for planarizing (that is, grinding or polishing) a surface of a flat workpiece such as a semiconductor wafer are known since the past. For example, PTL 1 discloses a polishing method in which an anodizing process and a polishing process are simultaneously or alternately progressed. In the anodizing process, a voltage is applied with the workpiece as a positive electrode in the presence of an electrolytic solution and the surface of the workpiece is oxidized. In the polishing process, the oxide formed on the surface of the workpiece is removed by polishing with a fixed abrasive polishing body in which abrasive grains having predetermined hardness and grain size are fixed onto a substrate. This polishing method is referred to as ECMP. ECMP is an abbreviation of Electro-Chemical Mechanical Polishing.

Specifically, PTL 1 discloses a polishing apparatus that is suitable for polishing an SiC wafer. In the polishing apparatus, a container is fixed onto a rotatable circular disk with an insulating body therebetween, and a metal plate that serves as a negative electrode is laid on a bottom surface of the container. The SiC wafer is held by a rotatable wafer holder and pressed against a grindstone at a predetermined load in an electrolytic solution. The wafer holder is suctioned to a vacuum chuck provided on a lower surface of a rotating head with an insulating layer therebetween. Then, as a result of a positive potential being applied with the SiC wafer as a working electrode, the surface of the SiC wafer is reformed by anodizing. The reformed layer is removed by the grindstone and, as a result, the surface is gradually planarized and a damage-free surface is obtained.

### [Citation List]

### [Patent Literature]

[PTL 1] JP 2021-027359 A

### [Summary]

To stably perform ECMP such as that described above, that is, polishing with the aid of anodizing, various functions are required of the chuck apparatus that holds the wafer. For example, in addition to a holding function for holding the wafer, an energization function for energizing the wafer, an insulation function against other sections of the polishing apparatus, and the like may be provided. In this regard, PTL 1 does not disclose at all such required functions related to the chuck apparatus or specific structures for actualizing the required functions. The present disclosure has been implemented in light of circumstances provided as examples above and the like. That is, for example, the present disclosure may provide a chuck apparatus that enables wafer planarization (that is, polishing or grinding) with the aid of anodizing to be stably performed.

According to an aspect of the present disclosure, a chuck apparatus is configured to hold a wafer during planarization of the wafer with the aid of anodizing.

The chuck apparatus includes: a suction portion having a suction surface that suctions the wafer; an energizing portion provided in the suction portion so as to come into contact with and energize the wafer suctioned by the suction portion; and a chuck cover that covers the suction portion and the energizing portion in an insulating manner while exposing the suction surface.

Here, in each section of the application documents, elements may be given reference numbers that are in parentheses. However, these reference numbers merely indicate examples of corresponding relationships between the elements and specific means described according to the embodiment described hereafter. Therefore, the present disclosure is not limited in any way by the above-described reference numbers.

### [Brief Description of Drawings]

In the accompanying drawings:
Fig. 1 is a cross-sectional side view of an overall configuration of a surface processing apparatus including a chuck apparatus according to an embodiment of the present disclosure;
Fig. 2A is a graph of the results of an evaluation of a relationship between size and shape of an energizing portion and variations in oxidation speed in the chuck apparatus shown in Fig. 1;
Fig. 2B is a graph of the results of an evaluation of the relationship between the size and shape of the energizing portion and variations in oxidation speed in the chuck apparatus shown in Fig. 1;
Fig. 2C is a graph of the results of an evaluation of the relationship between the size and shape of the energizing portion and variations in oxidation speed in the chuck apparatus shown in Fig. 1;
Fig. 3 is a bottom view of an example of an array of contact electrodes in an in-plane direction when the contact electrode shown in Fig. 1 is formed in a pin shape;
Fig. 4 is a bottom view of another example of an array of contact electrodes in the in-plane direction when the contact electrode shown in Fig. 1 is formed in a pin shape;
Fig. 5 is a cross-sectional side view of an overall configuration of the surface processing apparatus including the chuck apparatus in a modification; and
Fig. 6 is a cross-sectional side view of an overall configuration of the surface processing apparatus including the chuck apparatus in another modification.

### [Description of Embodiments]

### (Embodiments)

Embodiments of the present disclosure will hereinafter be described with reference to the drawings. Here, if various modifications applicable to an embodiment are inserted in the middle of a series of descriptions related to the embodiment, understanding of the embodiment may be compromised. Therefore, the modifications are collectively described after the series of descriptions related to the embodiment, rather than being inserted in the middle thereof.

### (Embodiment: Overall configuration)

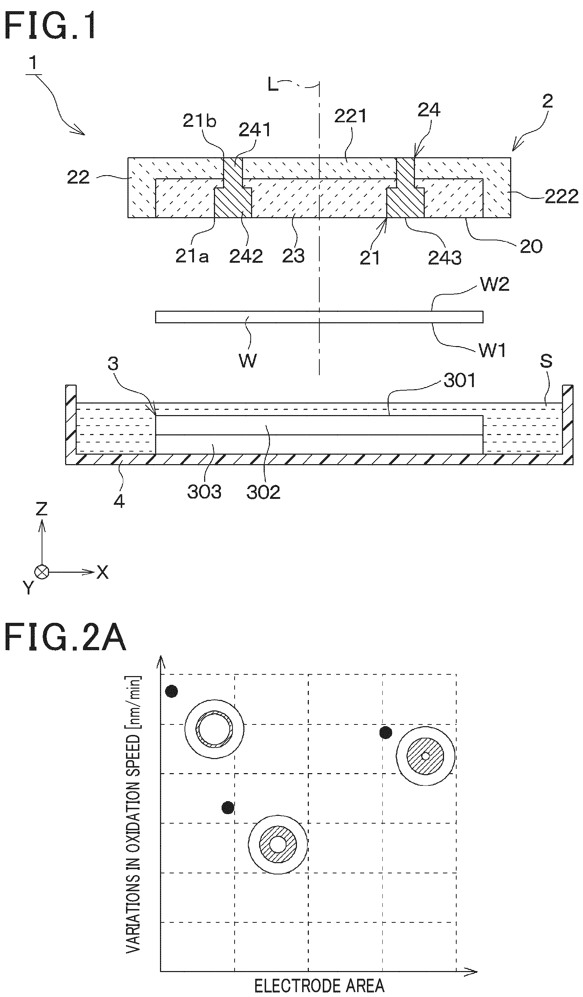

With reference to Fig. 1, a surface processing apparatus 1 is configured to planarize a surface W1 to be processed that is a main surface of a wafer W that is a flat workpiece. The "main surface" is a surface orthogonal to a plate thickness direction of a plate-shaped object and may also be referred to as a "plate surface". That is, the wafer W has the surface W1 to be processed that is one of a pair of main surfaces and a surface W2 to be suctioned that is the other, or in other words, a back surface. The surface processing apparatus 1 according to the present embodiment is configured to be capable of performing, with a semiconductor wafer such as an SiC wafer as the workpiece, a polishing process or a grinding process on the surface W1 to be processed of the workpiece with the aid of anodizing. In other words, the surface processing apparatus 1 has a configuration as an ECMP apparatus or an ECMG apparatus. ECMG is an abbreviation of Electro-Chemical Mechanical Grinding.

Hereafter, an overall configuration of the surface processing apparatus 1 according to the present embodiment will be described with reference to Fig. 1. Here, to simplify the description, a right-handed XYZ coordinate system is set as shown in the drawings. According to the present embodiment, a Z-axis positive direction indicates a vertically upward direction, that is, a direction opposite to a direction in which weight acts. In addition, an X-axis direction and a Y-axis direction both indicate horizontal directions. Hereafter, for convenience of description, the Z-axis positive direction side corresponding to the vertically upward direction is simply referred to as "up" and the opposite thereto is simply referred to as "down". Here, Fig. 1 is a schematic diagram simplified to concisely describe details of the present disclosure and does not limit in anyway the details of the present disclosure. Therefore, it goes without saying that Fig. 1 and a diagram that shows a detailed configuration that is actually manufactured and sold do not necessarily match. This similarly applies to up/down directions, upper/lower positional relationships between constituent elements, and the like. This also similarly applies to other configuration diagrams.

The surface processing apparatus 1 includes a chuck apparatus 2, a processing pad 3, and a container 4. The chuck apparatus 2 is configured to hold the wafer W during planarization of the wafer W with the aid of anodizing. Specifically, in the example shown in Fig. 1, the chuck apparatus 2 is configured to suction the surface W2 to be suctioned of the wafer W, thereby holding the wafer W while exposing the surface W1 to be processed below. In addition, the chuck apparatus 2 is configured to be capable of rotating the wafer W that is being held around a center axis L parallel to the up/down direction. The processing pad 3 is provided below the chuck apparatus 2 so as to be arranged opposing the surface W1 to be processed of the wafer W held by the chuck apparatus 2.

The container 4 is formed into a bathtub-like shape that is open upward. The container 4 is arranged below the chuck apparatus 2 and the processing pad 3 so as to house the processing pad 3 and an electrolytic solution S. According to the present embodiment, the electrolytic solution S is a solution that does not contain an etchant component and may be, for example, an aqueous solution of sodium chloride, potassium chloride, sodium nitrate, or the like. The etchant component (that is, for example, hydrofluoric acid) is a component composing a solvent capable of dissolving an oxide film formed on the surface W1 to be processed by anodizing. The chuck apparatus 2 and/or the container 4 is provided to be capable of moving up and down by a elevating mechanism (not shown). In addition, the chuck apparatus 2 and/or the container 4 is provided to be capable of moving in the XY direction in the drawings by a translation mechanism (not shown). Furthermore, the surface processing apparatus 1 is configured to generate the oxide film on the surface W1 to be processed by applying a current with the processing pad 3 side as a negative electrode and the wafer W side as a positive electrode in the presence of the electrolytic solution S, and selectively remove the generated oxide film by the processing pad 3.

### (Chuck apparatus)

The chuck apparatus 2 is configured to be capable of energizing the wafer W while holding the wafer W by suctioning the surface W2 to be suctioned of the wafer W with negative pressure to a horizontally planar suction surface 20 that is exposed below. That is, the chuck apparatus 2 has a configuration as a vacuum chuck apparatus that suctions the wafer W to the suction surface 20 with negative pressure. In addition, the chuck apparatus 2 is provided with an electrode mounting hole 21. The electrode mounting hole 21 is formed into a stepped shape that has a large diameter portion 21a that is open on the suction surface 20 and a small diameter portion 21b that is provided above the large diameter portion 21a so as to communicate with the large diameter portion 21a. For example, the electrode mounting hole 21 may be formed in a ring shape that surrounds the center axis L. Alternatively, a plurality of electrode mounting holes 21 formed into stepped circular holes may be two-dimensionally arrayed in an in-plane direction. The in-plane direction is a direction along the suction surface 20 and is a direction parallel to the XY plane in the drawing. Specifically, for example, the plurality of electrode mounting holes 21 may be arrayed on a circumference surrounding the center axis L.

The chuck apparatus 2 includes a chuck cover 22, a suction portion 23, and a contact electrode 24. The chuck cover 22 is configured to cover the suction portion 23 and the contact electrode 24 in an insulating manner while exposing the suction surface 20 provided in the suction portion 23. That is, the chuck cover 22 has an upper cover portion 221 that covers an upper portion of the suction portion 23 and a side cover portion 222 that covers a side of the suction portion 23. The chuck cover 22 is integrally formed by an insulating material (such as an insulating ceramic).

The suction portion 23 has the suction surface 20 that suctions the wafer W with negative pressure. In the example shown in Fig. 1, the suction portion 23 is formed in a plate shape having an internal passage through which air or negative pressure is able to pass in a plate thickness direction with the suction surface 20 as a bottom surface, by an insulating porous material such as porous ceramic. That is, the suction portion 23 has a configuration as a so-called porous chuck. At least the large diameter portion 21a of the electrode mounting hole 21 is provided in the suction portion 23.

The contact electrode 24 serving as an energizing portion is provided in the suction portion 23 so as to come into contact with and energize the wafer W attached to the suction portion 23, that is, the suction surface 20. In the example shown in Fig. 1, the contact electrode 24 is embedded in the suction portion 23 so as to be exposed on the suction surface 20. Specifically, the contact electrode 24 has an outer shape corresponding to the electrode mounting hole 21 and is detachably mounted in the suction portion 23 by being fitted into the electrode mounting hole 21. That is, the contact electrode 24 has a base portion 241 that is fitted into the small diameter portion 21b and an exposed portion 242 that is fitted into the large diameter portion 21a. The exposed portion 242 has a contact surface 243 that comes into contact with the surface W2 to be suctioned of the wafer W by being exposed on the suction surface 20. The contact surface 243 is provided flush with the suction surface 20 so that lifting of the wafer W from the suction surface 20 does not occur in a state of contact with the surface W2 to be suctioned. The contact electrode 24 is integrally formed by a low-resistance conductor such as copper. When the electrode mounting hole 21 is formed in a ring shape surrounding the center axis L, the contact electrode 24 is formed in a ring shape. Meanwhile, when the electrode mounting hole 21 is formed in a circular hole shape, the contact electrode 24 is formed in a pin shape.

In a state in which a processing surface 301 that is an upper surface of the processing pad 31 opposes the surface W1 to be processed of the wafer W held by the chuck apparatus 2 with the electrolytic solution S therebetween, the processing pad 3 is provided to planarize the surface W1 to be processed while sending a current with the wafer W as a positive electrode. According to the present embodiment, the processing pad 3 has a configuration for selectively removing an oxide generated on the surface W1 to be processed while anodizing the surface W1 to be processed in the presence of the electrolytic solution S. That is, the processing pad 3 has a two-layer structure in which a grindstone layer 302 having the processing surface 301 and an opposing electrode layer 303 that is a conductor layer of a conductive metal carrying the grindstone layer 302 are joined. The processing pad 3 may also be referred to as a "polishing pad" or a "grinding pad".

### (Embodiment: Workings and effects)

Hereafter, an overview of operations of the surface processing apparatus 1 including the chuck apparatus 2 according to the present embodiment will be described together with effects achieved by the configuration of the chuck apparatus 2.

First, the electrolytic solution S is pooled in an internal space of the container 4 housing the processing pad 3 such that a liquid level of the electrolytic solution S is above the processing surface 301. In addition, as shown in Fig. 1, in a state in which the chuck apparatus 2 is separated from the processing pad 3 and the container 4 in the up/down direction, the wafer W is suctioned to the suction portion 23 of the chuck apparatus 2 with negative pressure. Next, the chuck apparatus 2 suctioning the wafer W and the container 4 housing the processing pad 3 and the electrolytic solution S are brought closer together until the surface W1 to be processed and the processing surface 301 come into contact in the presence of the electrolytic solution S. Then, a current is applied with the processing pad 3 side as the negative electrode and the wafer W side as the positive electrode. In addition, the chuck apparatus 2 and the processing pad 3 are relatively rotated. As a result, the surface W1 to be processed that is anodized is ground or polished by the processing pad 3, thereby selectively removing an oxide film (that is, an oxide generated in a film-like shape) on the surface W1 to be processed. Consequently, the surface W1 to be processed can be favorably planarized.

Here, to stably perform ECMP or ECMG, that is, planarization of the wafer W with the aid of anodizing as described above, various functions are required of the chuck apparatus 2 that holds the wafer W. For example, in addition to a holding function for holding the wafer W, an energization function for energizing the wafer W and an insulation function against other sections of the surface processing apparatus 1 may be provided. As a result of these functions being actualized, wafer processing that is highly efficient and high in quality can be actualized.

In this regard, during processing in ECMP or ECMG, the wafer W that is the workpiece and the processing pad 3 are in a state of contact. Therefore, if a conventional vacuum chuck mechanism used in physical polishing or CMP differing from ECMP or ECMG is merely appropriated, energizing the wafer W from outside the conventional vacuum chuck mechanism is difficult. CMP is an abbreviation of chemical mechanical polishing.

Therefore, according to the present embodiment, the chuck apparatus 2 includes the chuck cover 22, the suction portion 23, and the contact electrode 24. The suction portion 23 has the suction surface 20 that suctions the wafer W with negative pressure. The contact electrode 24 is provided in the suction portion 23 so as to come into contact with and energize the wafer W suctioned by the suction portion 23. The chuck cover 22 covers the suction portion 23 and the contact electrode 24 in an insulating manner while exposing the suction surface 20 to enable holding, that is, suction of the wafer W. As a result of the chuck cover 22 covering the suction portion 23 and the contact electrode 24 in an insulating manner while the contact electrode 24 serving as the energizing portion is embedded in the suction portion 23, the holding function, the energization function, and the insulation function are favorably achieved. Consequently, ECMP and ECMG can be stably performed.

In addition, a favorable surface state after grinding or polishing can be achieved as a result of uniformity of the oxide film on the surface W1 to be processed being ensured. Uniformity of the oxide film is thought to be affected by uniformity in the in-plane direction of the energization state of the wafer W. Uniformity in the in-plane direction of the energization state of the wafer W is affected by an arrangement state (such as an area proportion) of an exposed portion 242, that is, the contact surface 243 of the contact electrode 24 exposed on the suction surface 20.

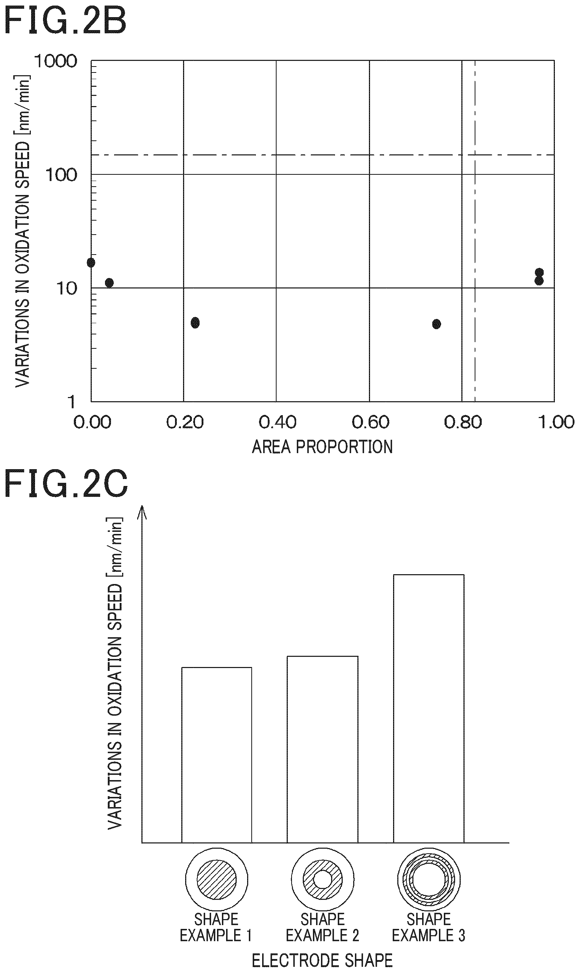

Fig. 2A to Fig. 2C show the results of evaluations of a relationship between size and shape of the contact surface 243 and variations in oxidation speed. In Fig. 2A to Fig. 2C, a vertical axis indicates variations in oxidation speed. Fig. 2A shows a relationship between an area of the contact surface 243 and the variations in oxidation speed. A horizontal axis in Fig. 2A indicates an electrode area, that is, the area of the contact surface 243. In addition, beside each plot in Fig. 2A, an in-plane shape of the contact surface 243 is shown. Fig. 2B shows a relationship between the area proportion of the electrode area in the suction surface 20 and the variations in oxidation speed. Here, a horizontal single-dot chain line in Fig. 2B indicates a boundary of an ECMP establishment condition. That is, ECMP processing is possible under conditions below the single-dot chain line in Fig. 2B. In addition, a vertical single-dot chain line in Fig. 2B indicates a wafer holding limit. That is, stable holding of the wafer W to the suction surface 20 is possible under conditions to the left of the vertical single-dot chain line in Fig. 2B, that is, when the area proportion is equal to or less than 0.83. A value of the area proportion at the leftmost plot in Fig. 2B is 0.00017. Fig. 2C shows a relationship between an electrode shape, that is, the shape of the contact surface 243 and the variations in the oxidation speed.

In principle, when an outer shape of the suction surface 20 is fixed, uniformity in the in-plane direction of the energization state is thought to improve as the electrode area increases. However, when the electrode area is too large, uniformity in the in-plane direction of the energization state is contrarily expected to worsen as a result a suction state, that is, a contact state between the contact surface 243 and the surface W1 to be processed becoming unstable. Therefore, a graph in a case in which the horizontal axis is the electrode area and the vertical axis is the variations in oxidation speed is expected to have a substantially V-like shape or a U-like shape in which a center portion is low. That is, an optimal electrode area is determined from a trade-off relationship between increase in energization area and decrease in suction force accompanying increase in electrode area. Then, the electrode area is optimized at a maximum area without compromising suction force. The graph shown in Fig. 2A matches this expectation. Upon evaluating the variations in oxidation speed by varying the area proportion, as shown in Fig. 2B, the area proportion of the electrode area in the suction surface 20 is preferably 0.00017 to 0.83 (that is, 0.017% to 83%) and more preferably 0.2 to 0.75 (that is, 20% to 75%). That is, when the electrode area is S1, and a sum of the electrode area and the area of the suction surface 20 is S2, an area proportion DS = S1 / S2 = 0.00017 to 0.83 is preferable and 0.2 to 0.75 is more preferable. When a radius of a substantially circular suction surface 20 is R, S2 = πR².

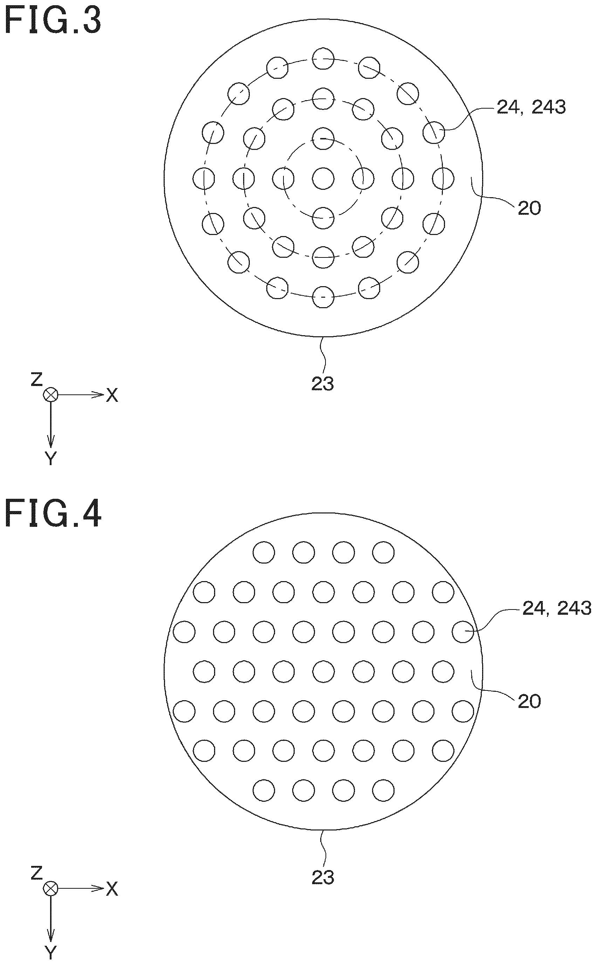

In Fig. 2C, shape example 1 is that in which the electrode shape is a circular shape in which an outer diameter is half an outer diameter of the suction surface 20 with an intersection between a plane including the suction surface 20 and the center axis L as the center. Shape example 2 is a circular annular shape that has a same outer diameter as the shape example 1. Upon comparison of the shape example 1 and the shape example 2, while the shape example 2 has a smaller electrode area than the shape example 1, the suction state, that is, the contact state between the contacting surface 243 and the surface W1 to be processed is stabilized by the suction surface 20 being provided in the center portion. Therefore, in the shape example 2, the variations in oxidation speed are substantially equal to that in the shape example 1 or slightly improved. Shape example 3 has a same electrode area as the shape example 2, and the electrode shape is modified from a single annular shape to a double annular shape. As a result of the shape example 3, the variations in oxidation speed significantly improve from that of the shape example 2. In this manner, even when the electrode area is the same, the variations in oxidation speed can be improved as a result of the contact surface 243 being uniformly dispersed in the in-plane direction. Specifically, for example, when the contact electrode 24 is formed in a pin shape that is a substantially circular column shape, as shown in Fig. 3, a single contact electrode 24 can be arranged in the center of the suction surface 20 and a plurality of contact electrodes 24 can be arranged at even intervals on a circumference surrounding the center. The array of the plurality of contact electrodes 24 in the circumferential shape may be provided in a plurality of rows in a concentric shape. Alternatively, as shown in Fig. 4, the plurality of contact electrodes 24 may be arranged in a dispersed manner so as to be as uniform as possible in the in-plane direction.

The contact electrode 24 may deteriorate as a result of oxidation and wear. In addition, modification to resistivity of the contact electrode 24 may be desired to change oxidation conditions, that is, anodizing current density. In this regard, such requirments can be appropriately addressed as a result of the contact electrode 24 being detachable, that is, easily exchangeable from the suction portion 23.

### (Modifications)

The present disclosure is not limited to the above-described embodiment. Therefore, modifications can be made as appropriate to the above-described embodiment. Hereafter, representative modifications will be described. In the descriptions of the modifications below, differences with the above-described embodiment will mainly be described. In addition, sections in the above-described embodiment and the modifications that are identical or equivalent to each other are given the same reference numbers. Therefore, in the descriptions of the modifications below, the description according to the above-described embodiment may be applied as appropriate regarding constituent elements that have the same reference numbers as those according to the above-described embodiment, unless technical inconsistencies or special additional descriptions are present.

The present disclosure is not limited to the exemplary apparatus configuration described according to the above-described embodiment. That is, Fig. 1 is a simplified schematic diagram for simply describing an overview of the chuck apparatus 2 of the present disclosure. Therefore, a configuration of the surface processing apparatus 1 that is actually manufactured and sold does not necessarily match the exemplary configuration shown in Fig. 1. In addition, the configuration of the surface processing apparatus 1 that is actually manufactured and sold may be modified as appropriate from the exemplary configuration shown in Fig. 1.

The electrolytic solution S may contain an etchant component. That is, the surface processing apparatus 1 of the present disclosure and a surface processing method that can be performed by the surface processing apparatus 1 may be that in which the surface W1 to be processed is polished or ground by the oxide film generated by anodizing being selectively removed using both an etchant and the processing pad 3.

According to the above-described embodiment, the surface processing apparatus 1 has a configuration in which planarization of the surface W1 to be processed is performed in a state in which the electrolytic solution S is pooled in the internal space of the container 4 such that the liquid level of the electrolytic solution S is above the processing surface 301 of the processing pad 3. However, the present disclosure is not limited to this configuration. That is, for example, the electrolytic solution S may be sprayed from a nozzle.

For example, in the exemplary configuration shown in Fig. 1, the chuck apparatus 2 may be positioned above the processing pad 3. However, the present disclosure is not limited to this configuration. That is, for example, the chuck apparatus 2 may be positioned below the processing pad 3. In this case, the description of the up/down relationship according to the above-described embodiment is reversed. The suction surface 20 and the processing surface 301 are not required to be parallel to a horizontal plane or a vertical plane and may be slanted thereto.

According to the above-described embodiment, the chuck apparatus 2 is configured such that the chuck cover 22 and the suction portion 23 are rotatable around the center axis L. However, the present disclosure is not limited to this aspect. That is, for example, the processing pad 3 may be provided so as to be capable of rotating around a rotation center axis parallel to the Z axis in the drawings by a rotation mechanism (not shown).

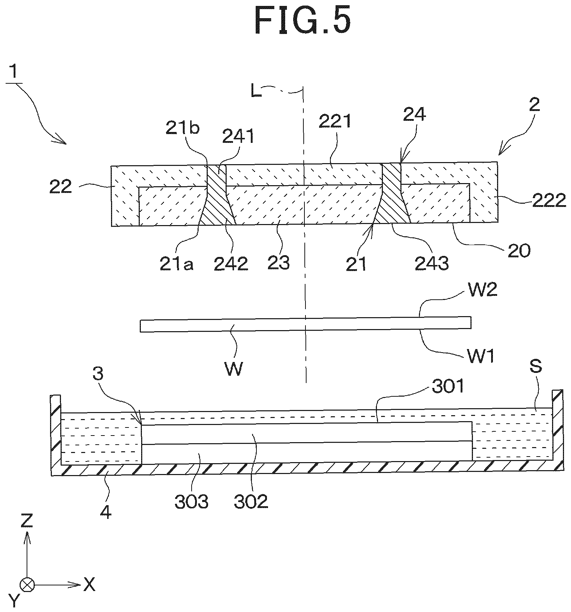

As shown in Fig. 5, the large diameter portion 21a of the electrode mounting hole 21 may be formed as a tapered hole of which a width in the in-plane direction widens towards the suction surface 20 along the axial direction parallel to the center axis L. In correspondence thereto, the contact electrode 24 may also be formed into a conical shape of which the width in the in-plane direction widens towards the contact surface 243 along the axial direction.

The electrode mounting hole 21 is not limited to the shape having the large diameter portion 21a and the small diameter portion 21b. That is, for example, the electrode mounting hole 21 may be formed such that the width in the in-plane direction is fixed. In correspondence thereto, the contact electrode 24 may also be formed such that the width in the in-plane direction is fixed.

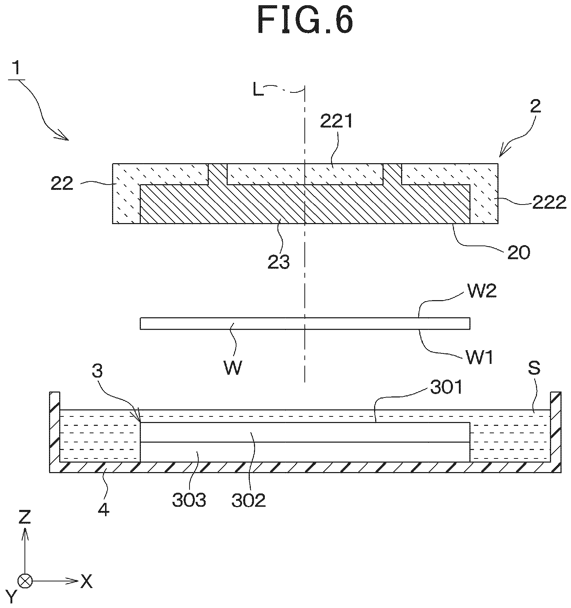

The suction portion 23 may be inseparably integrally formed with the energizing portion. Fig. 6 shows a configuration corresponding to this aspect. That is, the suction portion 23 is formed by a conductor that conducts to the wafer W through contact with the surface W2 to be suctioned. Specifically, the suction portion 23 has a configuration as a porous metal sintered body plate or a porous carbon plate (that is, a conductive porous body) through which air is able to pass in the plate thickness direction. Alternatively, the suction portion 23 may have a configuration in which a conductive adhesive layer or sticky layer is formed on a bottom surface of a block-shaped or plate-shaped electrode body. In this manner, as a result of the suction portion 23 having a structure that is also an electrode or an energizing portion (that is, a structure also functioning as an energizing portion), the configuration of the chuck apparatus 2 can be simplified. In addition, as a result of the energization state of the wafer W being made uniform in the in-plane direction, favorable planarization of the surface W1 to be processed can be actualized.

"With the aid of anodizing" can also be expressed as "with the use of anodizing".

In the description above, a plurality of constituent elements that are seamlessly integrally formed may be formed by members that are separate from each other being pasted together. In a similar manner, a plurality of constituent elements that are formed by members that are separate from each other being pasted together may be seamlessly integrally formed. In addition, in the description above, a plurality of constituent elements that are formed by the same materials as each other may be formed by different materials from each other. In a similar manner, a plurality of constituent elements that are formed by different materials from each other may be formed by the same materials as each other.

It goes without saying that an element that configures an above-described embodiment is not necessarily a requisite unless particularly specified as being a requisite, clearly considered a requisite in principle, or the like. In addition, in cases in which a numeric value, such as quantity, numeric value, amount, or range, of a constituent element is stated, the present disclosure is not limited to the specific number unless particularly specified as being a requisite, clearly limited to the specific number in principle, or the like. In a similar manner, when a shape, a direction, a positional relationship, or the like of a constituent element or the like is mentioned, excluding cases in which the shape, the direction, the positional relationship, or the like is clearly described as particularly being a requisite, is clearly limited to a specific shape, direction, positional relationship, or the like in principle, or the like, the present disclosure is not limited to the shape, direction, positional relationship, or the like.

The modifications are also not limited to the examples provided above. In addition, a plurality of modifications may be combined with each other. Furthermore, all or a portion of the above-described embodiments and all or a portion of the modifications may be combined with each other.

## Claims

1. A chuck apparatus (2) that holds a wafer (W) during planarization of the wafer with the aid of anodizing, the chuck apparatus comprising:
a suction portion (23) that includes a suction surface (20) that suctions the wafer;
an energizing portion (24) that is provided in the suction portion so as to come into contact with and energize the wafer suctioned by the suction portion; and
a chuck cover (22) that covers the suction portion and the energizing portion in an insulating manner while exposing the suction surface.

2. The chuck apparatus according to claim 1, wherein:
the suction portion is configured to suction the wafer to the suction surface with negative pressure.

3. The chuck apparatus according to claim 1 or 2, wherein:
the energizing portion is embedded in the suction portion so as to be exposed on the suction surface.

4. The chuck apparatus according to claim 3, wherein:
the energizing portion is detachably mounted to the suction portion.

5. The chuck apparatus according to claim 4, wherein:
the energizing portion is formed in a pin shape by a conductor.

6. The chuck apparatus according to any one of claims 1 to 5, wherein:
an area proportion of an exposed portion (242) of the energizing portion exposed on the suction surface in the suction surface is 0.00017 to 0.83.

7. The chuck apparatus according to claim 2, wherein:
the suction portion is formed by a conductive porous body to also function as the energizing portion.
